# FASCICULE DE BREVET EUROPEEN

(11) **EP 3 193 438 B1**
(45) Date de publication et mention de la délivrance du brevet: **31.07.2019**
(21) Numéro de dépôt: 16202811.2
(22) Date de dépôt: 08.12.2016
(51) Int. Cl.: H02M 3/156, H02M 7/06, H02M 1/08, H03K 3/0231, H05B 33/08, H05B 39/04

(54) **DISPOSITIF D'ALIMENTATION ÉLECTRIQUE**
STROMVERSORGUNGSVORRICHTUNG
ELECTRICAL POWER SUPPLY DEVICE

(30) Priorité: 15.01.2016 FR 1650329
(43) Date de publication de la demande: 19.07.2017
(73) Titulaire: Schneider Electric Industries SAS, 92500 Rueil-Malmaison (FR)
(72) Inventeur: WANG, Miao-Xin, 38050 GRENOBLE (FR); CORTESE, Gilles, 38050 GRENOBLE (FR)
(74) Mandataire: Tripodi, Paul

(56) Documents cités:
- EP-A2- 0 264 765
- WO-A1-2015/145014
- GB-A- 1 124 990
- JP-A- H02 156 167
- US-A- 3 551 704

## Description

### Domaine technique de l'invention

La présente invention se rapporte à un dispositif d'alimentation électrique destiné par exemple à être connecté en parallèle d'un interrupteur de commande d'une charge électrique, sur un système de commande de type va-et-vient, ou directement entre les deux bornes d'une source d'alimentation électrique.

### Etat de la technique

Un système de commande d'une charge électrique telle qu'une ampoule électrique comporte classiquement un interrupteur de commande chargé de commander le passage d'un courant électrique dans l'ampoule électrique.

Il est connu de connecter différents dispositifs en parallèle d'un interrupteur de commande, par exemple un indicateur de signalisation, un gradateur, une minuterie, un capteur de type capacitif, infrarouge ou un récepteur sans-fil fonctionnant sous un protocole de communication tel que Zigbee ou Bluetooth.

Le dispositif étant en série avec l'ampoule électrique lorsque l'interrupteur est ouvert, son courant d'alimentation doit rester limité pour ne pas entraîner un éclairement, même faible, de l'ampoule électrique.

Tant que les ampoules étaient de type à incandescence ou halogène, le courant d'alimentation d'un tel dispositif était insuffisant pour faire éclairer l'ampoule électrique. Aujourd'hui, l'apparition des ampoules dites « à basse consommation » de type à LED ou fluorescente génère de nouvelles difficultés. En effet, ces ampoules n'ont besoin que d'un très faible courant pour fonctionner. Ainsi, lorsque l'interrupteur est à l'état ouvert, le courant d'alimentation du dispositif connecté en parallèle devient désormais suffisant pour entraîner un faible éclairement ou des clignotements d'une ampoule de ce type.

Une solution évidente consiste à réduire le courant d'alimentation du dispositif. Cependant, le dispositif peut alors être amené à mal fonctionner ou ne plus fonctionner du tout.

La demande de brevet WO2015/145014A1 décrit un circuit d'alimentation destiné à se connecter en parallèle d'un interrupteur de puissance et permettant de générer des impulsions de commande à l'aide d'un oscillateur pour alimenter un circuit électronique de commande. L'interrupteur de puissance est destiné à isoler ou relier électriquement deux bornes de connexion d'un dispositif de commande d'une charge telle qu'une lampe à incandescence ou une lampe à diodes électroluminescentes.

La solution proposée dans cette demande de brevet permet notamment d'éviter un éclairement visible de la lampe, même lorsque celle-ci est éteinte. Pour cela, l'oscillateur astable employé permet de générer des impulsions de commande avec un rapport cyclique très faible. Cependant, la solution proposée dans ce document ne permet un réglage fin des impulsions de commande générées.

Le brevet US 3 551 704 décrit un générateur d'impulsions fournissant un réglage indépendant de la durée et de la fréquence des impulsions. Un tel dispositif est destiné à un usage général et ne mentionne ou ne revendique pas une conception adaptée à l'utilisation du générateur d'impulsions en parallèle d'un interrupteur de commande d'ampoules « basse consommation ».

Le but de l'invention est de proposer un dispositif d'alimentation électrique qui permet d'alimenter des dispositifs tels que décrits ci-dessus lorsque ceux-ci sont par exemple connectés en parallèle d'un interrupteur de commande, même si la charge électrique commandée par l'interrupteur est une lampe dite « à basse consommation », permettant notamment un réglage fin des impulsions de tension générées.

### Exposé de l'invention

Ce but est atteint par un dispositif d'alimentation électrique selon la revendication 1.

Le dispositif d'alimentation électrique comporte un convertisseur (CONV) de tension pouvant être :
- du type abaisseur de tension,
- du type abaisseur-élévateur de tension, ou
- du type « flyback ».

Avantageusement, le dispositif d'alimentation pourra comporter un module électronique de régulation agencé pour réguler la tension de sortie à une valeur déterminée.

L'invention concerne également un système de commande d'une charge électrique comprenant au moins un interrupteur de commande commuté entre un état ouvert et un état fermé pour commander une charge électrique avec un courant de charge, ledit système comportant un dispositif d'alimentation tel que défini ci-dessus et étant connecté en parallèle dudit interrupteur de commande pour prélever une tension d'entrée alternative lorsque l'interrupteur de commande est à l'état ouvert en vue de générer en sortie une tension de sortie.

Avantageusement, ledit système pourra comporter un module électronique d'alimentation agencé pour prélever ledit courant de charge lorsque l'interrupteur de commande est à l'état fermé et connecté à la sortie dudit dispositif d'alimentation pour fournir ladite tension de sortie lorsque l'interrupteur de commande est à l'état fermé.

### Brève description des figures

D'autres caractéristiques et avantages vont apparaître dans la description détaillée qui suit faite en regard des dessins annexés dans lesquels :
- la figure 1 représente, de manière schématique, le dispositif d'alimentation de l'invention, destiné à être connecté en parallèle d'un interrupteur de commande d'une charge électrique, ou sur un système de commande de type va-et-vient, ou directement sur les deux bornes reliées à une source d'alimentation électrique
- la figure 2B représente un mode de réalisation de l'oscillateur, les figures 2A, 2C et2D représentent différents exemples de réalisation de l'oscillateur utiles à la compréhension de l'invention,
- les figures 3A à 3C représentent différentes variantes de réalisation du convertisseur de tension employé dans le dispositif de l'invention,
- les figures 4B à 4D représentent différentes variantes de réalisation du dispositif de l'invention, connecté en parallèle d'un interrupteur de commande d'une charge électrique, la figure 4A représente un exemple de réalisation utile à la compréhension de l'invention,
- la figure 5 représente un chronogramme illustrant le principe de fonctionnement de l'invention,
- la figure 6 représente le dispositif de l'invention connecté sur un système de commande de type va-et-vient.

### Description détaillée d'au moins un mode de réalisation

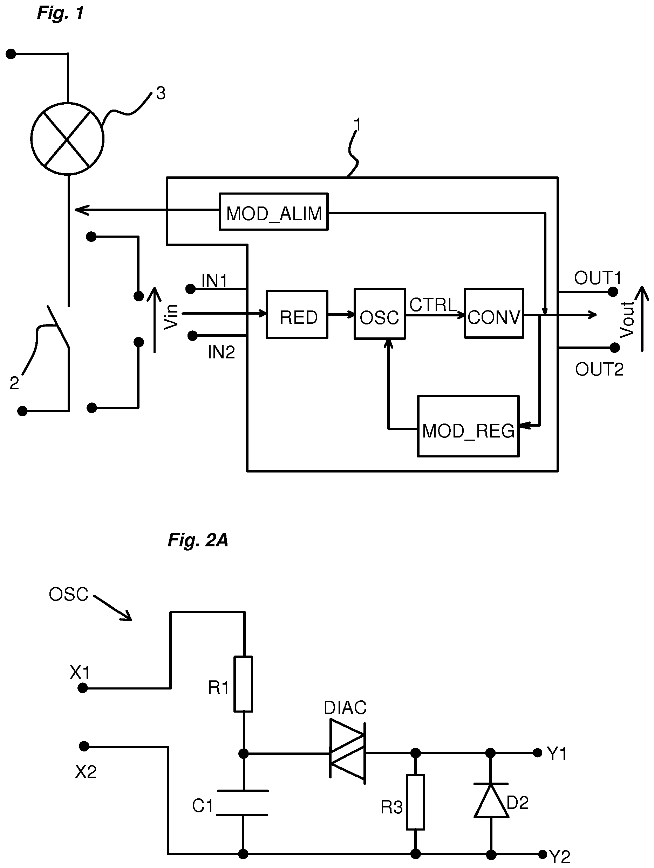

L'invention consiste à proposer un dispositif d'alimentation. En référence à la figure 1, ce dispositif d'alimentation 1 présente la particularité d'être connecté en parallèle d'un interrupteur de commande 2 d'une charge électrique, par exemple une lampe 3, reliée à une source d'alimentation alternative (non représentée), sur un système de commande de charge de type va-et-vient, ou directement aux deux bornes d'une prise électrique reliée à un réseau de distribution électrique. Par interrupteur de commande, on entend tout dispositif permettant la commande d'un circuit électrique, tel que par exemple un relais de commutation, bouton poussoir ou à levier.

Ce dispositif comporte ainsi au moins deux bornes d'entrée IN1, IN2 destinées à être connectées en parallèle de l'interrupteur de commande 2, aux deux bornes de la prise électrique ou sur le système de commande de type va-et-vient, comme décrit ci-dessus, pour recevoir une tension d'entrée Vin alternative et deux bornes de sortie OUT1, OUT2 entre lesquelles est générée une tension de sortie Vout continue.

Entre ces deux bornes d'entrée IN1, IN2 et ces deux bornes de sortie OUT1, OUT2, en référence à la figure 1, le dispositif 1 comporte :
- Un redresseur RED agencé pour redresser la tension alternative prélevée.
- Un oscillateur OSC agencé pour générer des impulsions de commande CTRL.
- Un convertisseur de tension CONV commandé par les impulsions de commande CTRL fournies l'oscillateur OSC en vue de fournir une tension de sortie Vout électrique continue à partir du courant électrique fourni par la source d'alimentation.

Préférentiellement, le dispositif pourra également comporter :
- Un module électronique d'alimentation MOD_ALlM par le courant de la charge, utile lorsque le dispositif 1 est connecté en parallèle d'un interrupteur de commande pour maintenir l'alimentation lorsque l'interrupteur de commande de la charge électrique est fermé et que la tension d'entrée Vin est nulle. Ce module électronique d'alimentation vient directement se connecter en série sur le circuit d'alimentation de la charge électrique.
- Un module électronique de régulation MOD_REG agencé pour obtenir une tension de sortie Vout sensiblement constante quelle que soit la variation de la tension d'entrée. Ce module est agencé pour se connecter sur la sortie du dispositif en vue de former une boucle de contre-réaction.

Ces différents composants formant le dispositif de l'invention sont détaillés ci-dessous. Le dispositif sera plus particulièrement décrit pour l'application dans laquelle il est connecté en parallèle d'un interrupteur de commande d'une charge électrique. Cependant, il faut comprendre qu'il peut être employé dans d'autres applications, telles que celles décrites ci-dessus.

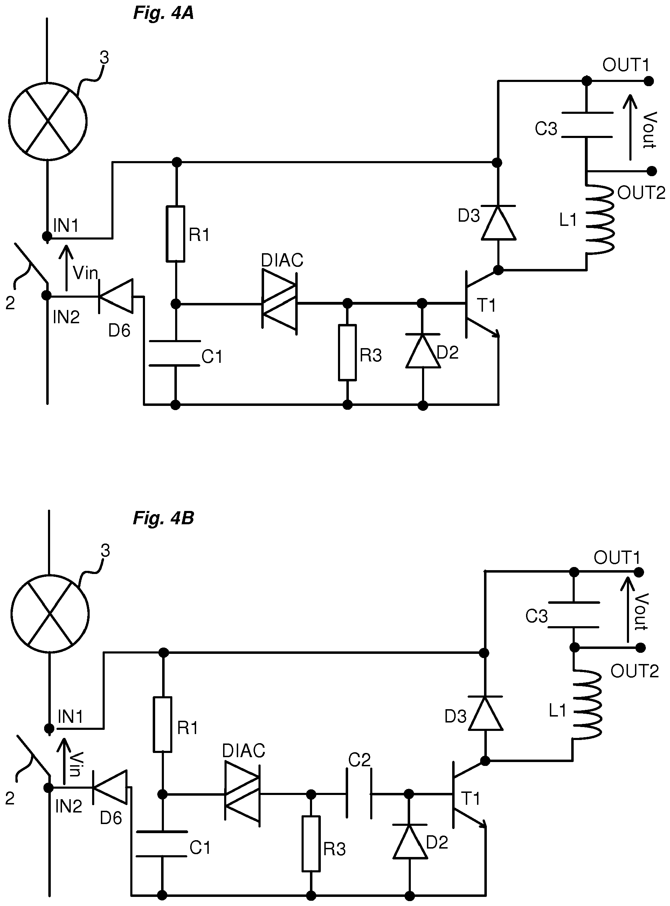

Le redresseur RED est agencé pour redresser la tension alternative prélevée entre les deux bornes disponibles sur lesquelles le dispositif est connecté. Le redresseur peut être composé par exemple d'une simple diode (D6 sur les figures annexées) connectée en série sur une borne d'entrée (IN2) du dispositif ou de toute autre solution permettant de redresser la tension prélevée, par exemple un pont de diodes. Sur les figures 4A à 4D, le redresseur est réalisé à l'aide de la diode D6.

L'oscillateur OSC peut être réalisé selon différentes variantes de réalisation détaillées ci-dessous.

En référence à la figure 2A, l'oscillateur, selon une première variante de réalisation présentée comme exemple utile à la compréhension de l'invention, comporte deux bornes amonts, désignées ci-après première borne amont X1 et deuxième borne amont X2, destinées à être connectée chacune à une borne d'entrée IN1, IN2 distincte du dispositif et deux bornes avals Y1, Y2. Sur ce premier schéma, l'oscillateur OSC comporte une diode commandée de type DIAC (Diode for Alternating Current). Cette diode DIAC est connectée d'une part à un point de connexion reliant une première résistance R1 à un premier condensateur C1 et d'autre part à sa première borne aval Y1. La première résistance R1 est également connectée à la première borne amont X1 de l'oscillateur OSC. Entre sa première borne aval Y1 et sa deuxième borne aval Y2, l'oscillateur OSC comporte une résistance R3 et une diode D2 connectée en parallèle.

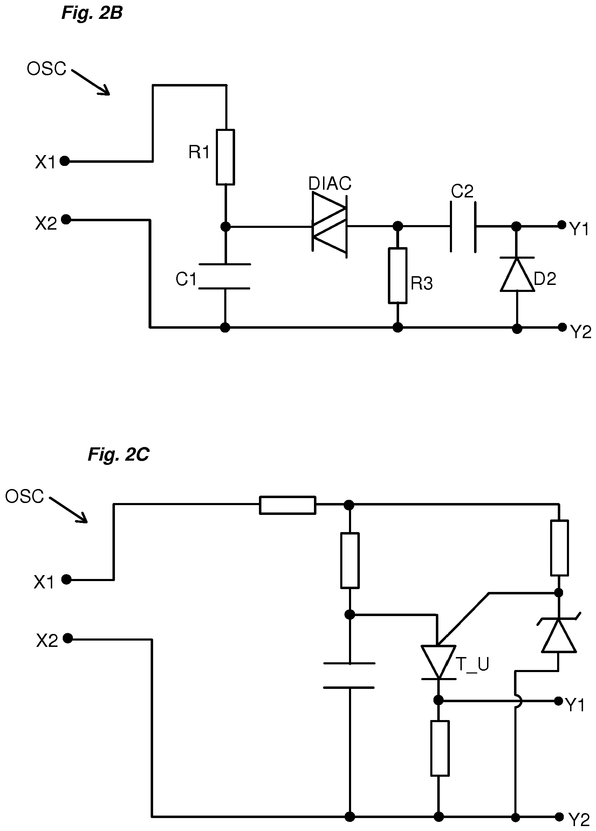

En référence à la figure 2B, l'oscillateur OSC, selon l'invention, comporte en plus, par rapport au premier exemple décrit ci-dessus, un condensateur C2 connecté d'une part à sa première borne aval Y1 et d'autre part à la diode de type DIAC. La résistance R3 est pour sa part connectée entre le point de connexion de la diode de type DIAC avec le condensateur C2 et la deuxième borne aval Y2 de l'oscillateur alors que la diode D2 reste connectée en parallèle entre la première borne aval Y1 et la deuxième borne aval Y2 de l'oscillateur.

En référence à la figure 2C, dans une autre variante de réalisation présentée comme exemple utile à la compréhension de l'invention, l'oscillateur OSC emploie un transistor à unijonction. Dans cette architecture, la diode de type DIAC est remplacée par un transistor à unijonction T_U.

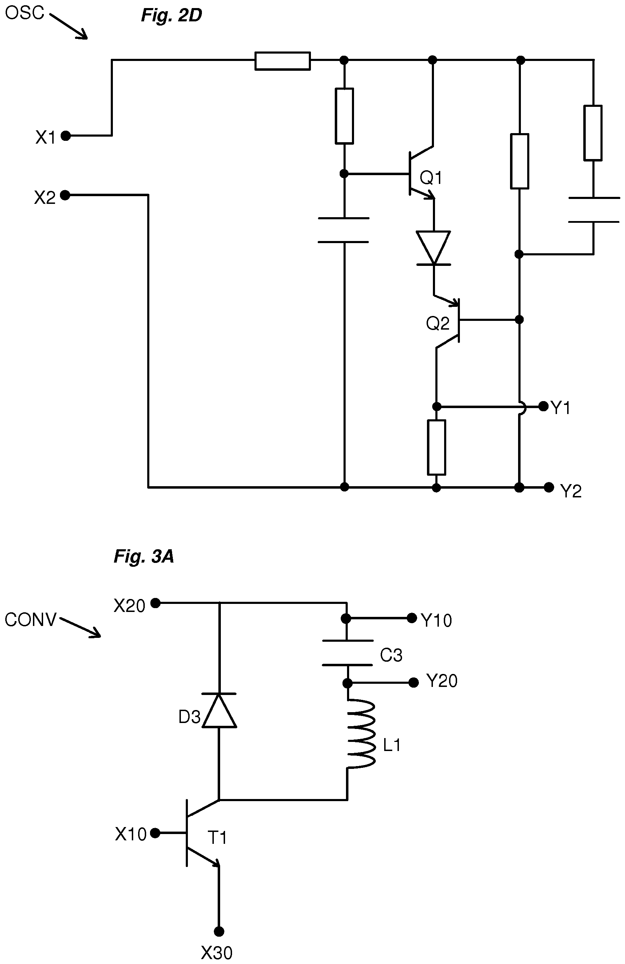

Sur la figure 2D, dans une dernière variante de réalisation présentée comme exemple utile à la compréhension de l'invention, l'oscillateur OSC emploie deux transistors Q1, Q2 connectés entre eux en cascade. Un premier transistor (Q1) est de type NPN et le deuxième transistor (Q2) est de type PNP.

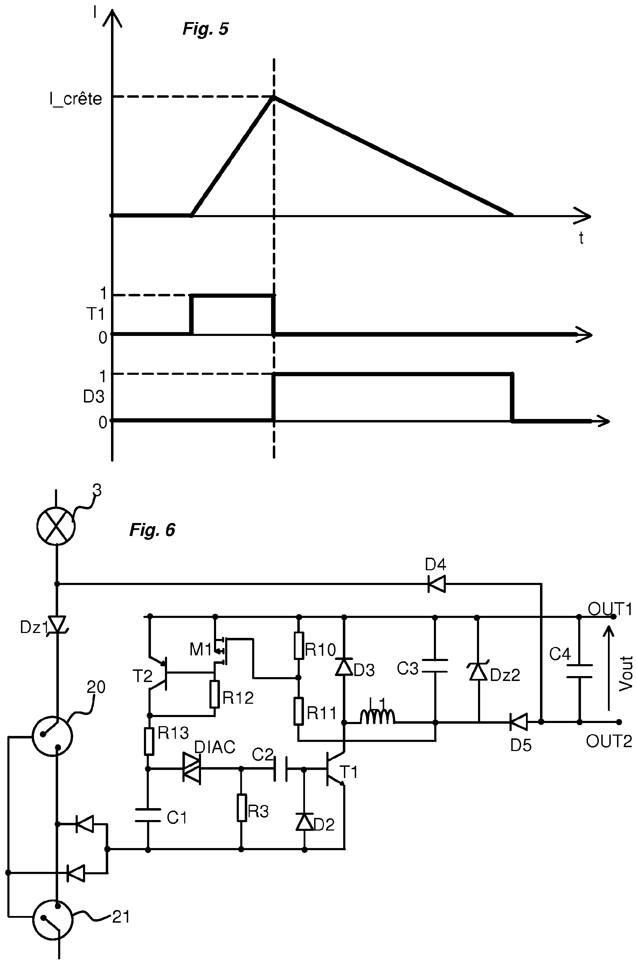

Quel que soit le mode de réalisation employé, le principe de fonctionnement de l'oscillateur reste identique. Il s'agit de générer des impulsions de commande pour commander le convertisseur connecté en sortie. Ce principe de fonctionnement sera explicité ci-après, notamment en liaison avec la figure 5.

Le convertisseur CONV peut être réalisé selon différentes variantes de réalisation détaillées ci-dessous. Ce convertisseur est commandé par les impulsions de commande CTRL fournies par l'oscillateur sur sa première borne aval Y1, en vue de générer une tension Vout continue en sortie. Il comporte trois bornes amonts, une première borne amont X10 destinée à être connectée à la première borne aval Y1 de l'oscillateur OSC pour recevoir les impulsions de commande CTRL fournies par l'oscillateur, une deuxième borne amont X20 destinée à être connectée à la première borne d'entrée IN1 du dispositif et une troisième borne amont X30 destinée à être connectée à la deuxième borne aval Y2 de l'oscillateur OSC. Il comporte également deux bornes avals Y10, Y20 entre lesquelles la tension de sortie Vout est générée.

La figure 3A représente un convertisseur de type abaisseur de tension (« buck »). Le convertisseur comporte ainsi un transistor T1 de type NPN dont la base est connectée à la première borne amont X10 du convertisseur, l'émetteur est connecté à la troisième borne amont X30 et le collecteur est connecté à la deuxième borne amont X20 du convertisseur à travers une diode de roue libre D3. Il comporte également une inductance L1 connectée au collecteur du transistor T1 et à la deuxième borne aval Y20, un condensateur C3 connecté à la première borne aval Y10 et à la deuxième borne aval Y20. La deuxième borne amont X20 est pour sa part connectée directement à la première borne aval Y10. La diode de roue libre D3 est connectée au collecteur du transistor T1 et à la deuxième borne amont X20 du convertisseur et orientée passante du collecteur vers la deuxième borne amont X20.

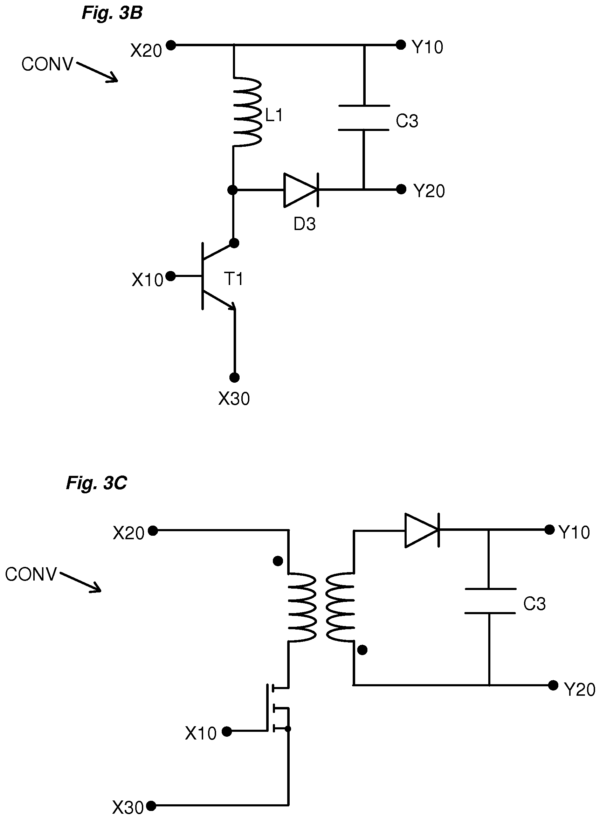

La figure 3B représente un convertisseur de type abaisseur-élévateur de tension (« buck-boost »). Son architecture étant bien connue, elle ne sera pas détaillée dans la présente demande.

La figure 3C représente un convertisseur de type « flyback ». Son architecture étant bien connue, elle ne sera pas détaillée dans la présente demande.

Les figures 4B à 4D représentent plusieurs variantes de réalisation du dispositif de l'invention, dans lesquelles le dispositif est connecté en parallèle d'un interrupteur de commande 2 d'une charge électrique.

La figure 4A représente un premier mode de réalisation du dispositif, présentée comme exemple utile à la compréhension de l'invention, employant un oscillateur OSC tel que représenté sur la figure 2A et un convertisseur CONV de type abaisseur tel que représenté sur la figure 3A et connecté audit oscillateur. La première borne amont X1 de l'oscillateur est connectée à la première borne d'entrée IN1 du dispositif et la deuxième borne amont X2 de l'oscillateur est connectée à la deuxième borne d'entrée IN2 du dispositif. La première borne amont X10 du convertisseur est ainsi connectée à la première borne aval Y1 de l'oscillateur OSC, la deuxième borne amont X20 du convertisseur CONV est connectée à la première borne d'entrée IN1 du dispositif 1 et la troisième borne amont X30 du convertisseur est connectée à la deuxième borne aval Y2 de l'oscillateur OSC. La première borne aval Y10 du convertisseur est connectée à la première borne de sortie OUT1 du dispositif et ta deuxième borne aval Y20 du convertisseur est connectée à la deuxième borne de sortie OUT2 du dispositif.

Le fonctionnement d'un tel dispositif est le suivant :
- Lorsqu'une tension d'entrée Vin est présente entre les deux bornes d'entrée IN1, IN2 du dispositif, celle-ci s'applique sur l'ensemble formé par la première résistance R1 et par le condensateur C1 de l'oscillateur OSC, entraînant la charge du condensateur C1 à travers la résistance R1.
- Lorsque la tension au point de connexion entre la résistance R1 et le condensateur C1 dépasse le seuil de mise en conduction de la diode de type DIAC, le condensateur C1 se décharge dans la jonction Base-Emetteur du transistor T1 du convertisseur.
- Le transistor T1 devient passant le temps de la décharge du condensateur C1, qui dure par exemple quelques dizaines de microsecondes.
- Le transistor T1 étant passant, l'inductance L1 du convertisseur emmagasine un courant de quelques dizaines de milliampères.
- Une fois la décharge du condensateur C1 terminée, la diode de type DIAC se bloque, entraînant aussi le blocage du transistor T1. Le courant emmagasinée par l'inductance s'écoule alors dans la diode de roue libre D3. Ce temps de décharge est plus long, de l'ordre de quelques centaines de microsecondes.
- L'impulsion de courant générée crée alors une tension de sortie Veut entre les deux bornes de sortie OUT1, OUT2 du dispositif.
- Le condensateur C1 se recharge à travers la résistance R1.
- Le phénomène de charge/décharge du condensateur C1 peut se produire plusieurs fois par alternance secteur, selon la valeur de la résistance R1.

Dans l'architecture décrite ci-dessus, la valeur de la résistance R1 détermine le nombre d'impulsions de courant générées par le dispositif et la valeur de la capacité du condensateur C1 détermine la durée de chaque impulsion de courant fournie par le dispositif. Dans le cas où le dispositif est connecté en parallèle d'un interrupteur de commande d'une charge électrique, pour que l'impulsion de courant générée par le dispositif ne soit pas vue par la charge électrique, il est nécessaire que celle-ci soit très courte. Par exemple, dans le schéma de la figure 4A, on emploiera une résistance R1 ayant une valeur inférieure à 30 méga ohms et un condensateur C1 ayant une capacité la plus faible possible pour réduire la durée de l'impulsion.

La figure 4B représente une variante de réalisation du dispositif. Cette variante utilise un oscillateur OSC ayant une architecture telle que représentée sur la figure 2B et emploie le même convertisseur CONV que la topologie de la figure 4A. L'agencement de l'oscillateur OSC et du convertisseur CONV dans le dispositif reste identique à celui-décrit ci-dessus pour la figure 4A. L'oscillateur OSC employé permet de dissocier la génération du nombre d'impulsions de la durée de chaque impulsion. Dans cette architecture, la valeur de la capacité du condensateur C1 détermine le nombre d'impulsions, tandis que la valeur de la capacité du condensateur C2 détermine la durée de chaque impulsion. La durée de conduction du transistor T1 du convertisseur ne dépend alors que de la valeur de la capacité du condensateur C2. Ainsi, la valeur de la résistance R1 et la capacité du condensateur C1 sont choisis de telle sorte que la charge/décharge du condensateur C1 se produise un nombre déterminé de fois par alternance de la tension Vin présente en entrée. A chaque conduction de la diode DIAC, le condensateur C2 se charge à travers la jonction Base-Emetteur du transistor T1 du convertisseur, provoquant sa mise en conduction. Une fois le condensateur C2 déchargé, le transistor T1 se bloque.

La figure 5 représente un chronogramme illustrant le fonctionnement du dispositif représenté sur la figure 4B. Sur cette figure, on remarque que le courant I qui traverse l'inductance L1 augmente sur la durée de conduction du transistor T1 du convertisseur jusqu'à une valeur I_crête. Lorsque le transistor T1 se bloque, ce courant I décroît jusqu'une valeur nulle en s'écoulant dans la diode de roue libre D3 qui est alors passante. Il faut donc noter que la valeur de l'inductance L1 du convertisseur détermine la valeur I_crête du courant généré par le dispositif.

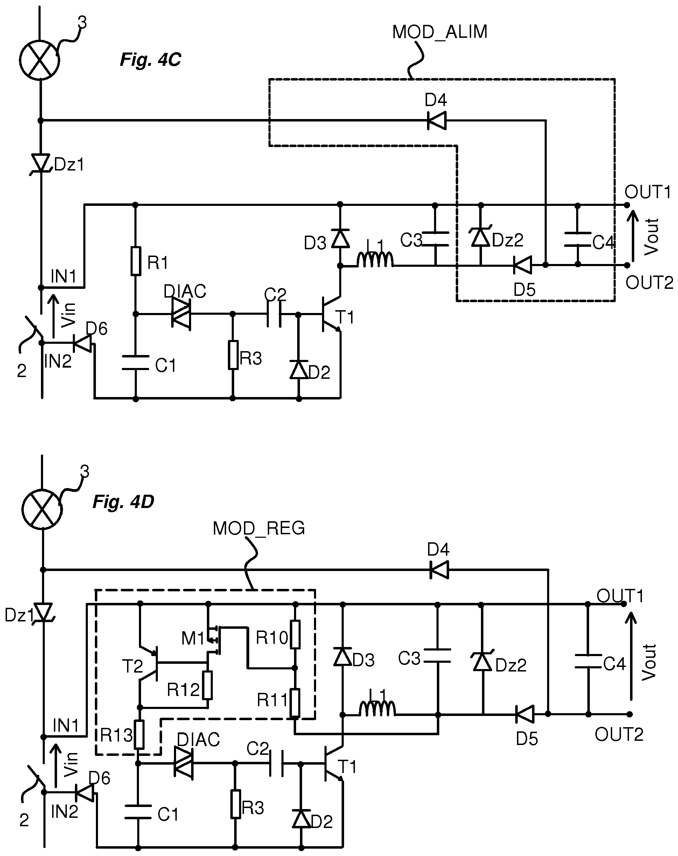

Lorsque le dispositif de l'invention est connecté en parallèle d'un interrupteur de commande d'une charge électrique, la solution décrite ci-dessus à base d'un oscillateur et d'un convertisseur permet de générer une tension de sortie lorsque l'interrupteur de commande est ouvert. Pour assurer la continuité de l'alimentation, même lorsque cet interrupteur de commande est fermé, le dispositif de l'invention comporte un module électronique d'alimentation MOD_ALlM agencé pour prélever directement le courant destiné à traverser la charge électrique. La figure 4C représente le dispositif de l'invention muni de ce module électronique d'alimentation. Sur cette figure, le dispositif comporte ainsi un oscillateur OSC du type de celui représenté sur la figure 2B, un convertisseur du type de celui représenté sur la figure 3A, connectés entre eux comme décrits ci-dessus et un module électronique d'alimentation MOD_ALIM supplémentaire. Le module électronique d'alimentation MOD_ALlM comporte pour sa part :
- Un composant connecté en série avec la charge électrique et comportant une résistance de shunt, une diode de type Zener (Dz1 sur la figure 4C) ou Transil ou un transformateur de courant.
- Une première diode D4 connectée dans le sens passant entre d'une part la deuxième borne de sortie OUT2 du dispositif et d'autre part le circuit de charge.
- Une deuxième diode D5 connectée dans le sens passant entre d'une part la deuxième borne de sortie OUT2 du dispositif et d'autre part la deuxième borne aval Y20 du convertisseur.
- Une diode Zener Dz2 connectée en parallèle du condensateur C3, c'est-à-dire entre les deux bornes de sortie OUT1, OUT2 du dispositif.
- Un condensateur C4 connecté aux deux bornes de sortie OUT1, OUT2 du dispositif 1 pour créer la tension de sortie.

L'agencement des deux diodes D4 et D5 permet d'éviter que les deux sources de tension, formées d'une part par le circuit de charge et d'autre part par le dispositif d'alimentation de l'invention, ne débitent l'une dans l'autre.

Préférentiellement, le dispositif de l'invention peut également intégrer un module électronique de régulation MOD_REG de la tension, comme représenté sur la figure 4D. En effet, les différentes topologies d'oscillateur présentent souvent l'inconvénient d'être sensibles à la tension d'entrée. Le nombre d'impulsions de commande générées tend à augmenter avec la tension fournie par la source d'alimentation. Il peut donc s'avérer nécessaire d'obtenir une alimentation suffisante quand la tension fournie par la source d'alimentation est minimale et que le courant prélevé ne vienne pas perturber la charge électrique lorsque la tension fournie par la source d'alimentation augmente.

Le module électronique de régulation MOD_REG de tension comporte ainsi une boucle de contre-réaction agencée pour limiter le nombre d'impulsions de commande générées par l'oscillateur.

La figure 4D représente ainsi le dispositif de l'invention incluant :
- Un redresseur, formé de la diode D6.
- Un oscillateur OSC tel que celui représenté sur la figure 2A.
- Un convertisseur CONV tel que celui représenté sur la figure 3A.
- Un module électronique d'alimentation tel que décrit ci-dessus en liaison avec la figure 4C.
- Un module électronique de régulation décrit plus précisément ci-dessous.

Le module électronique de régulation MOD_REG de tension est destiné à remplacer la résistance R1 de l'oscillateur OSC pour créer une résistance variable. Il comporte ainsi une première borne connectée à la diode de type DIAC, une deuxième borne connectée à la première borne d'entrée IN1 du dispositif 1 et une troisième borne connectée à la deuxième borne aval Y2 du convertisseur CONV. Il comporte :
- un pont diviseur à deux résistances R10, R11, connecté entre sa deuxième borne et sa troisième borne,
- un transistor M1 de type MOSFET, Canal P, dont la grille est connectée au point milieu du pont diviseur, la source est connectée sur sa deuxième borne et le drain est connecté à la base d'un transistor T2 de type PNP et à sa première borne à travers deux résistances R12, R13 en série.
- le transistor T2 dont la base est connectée au drain du transistor MOSFET, l'émetteur est connecté à sa deuxième borne et le collecteur est connecté au point de connexion des deux résistances R12, R13.

Le fonctionnement du module électronique de régulation MOD_REG est le suivant :
- Lorsque la tension présente aux bornes de la résistance R10 est inférieure au seuil de conduction du transistor M1, le transistor M1 est bloqué. Le transistor T2 est passant et la résistance équivalente pour charger le condensateur C1 de l'oscillateur OSC correspond approximativement à celle de la résistance R13.
- Lorsque la tension présente aux bornes de la résistance R10 devient supérieure au seuil de conduction du transistor M1, le transistor M1 devient passant. Le transistor T2 est alors commandé à l'état bloqué. La résistance équivalente pour charger le condensateur C1 de l'oscillateur correspond approximativement à la somme des deux résistances R12 et R13.

La figure 6 illustre l'emploi du dispositif de l'invention pour un système de commande d'une charge électrique de type va-et-vient. Pour cette application, la deuxième entrée du dispositif est dédoublée pour se connecter aux deux branches de circuit formées par le système de type va-et-vient. Le redresseur RED du dispositif comporte ainsi deux diodes distinctes connectées chacune à l'une des branches du système de type va-et-vient.

Le dispositif de l'invention tel que décrit ci-dessus présente de nombreux avantages. Il permet de générer une micro-alimentation électrique compatible avec de nombreux dispositifs, tels que capteurs, voyant, minuterie, gradateur, télécommande ou autre, et peut facilement se connecter en parallèle d'un interrupteur de commande d'une charge électrique ou directement entre les deux bornes d'une prise électrique pour prélever un courant de charge. Ce dispositif d'alimentation est particulièrement performant car il présente un rendement élevé et des pertes limitées. Il est par ailleurs compatible avec l'alimentation d'une charge électrique qui consomme très peu, comme les ampoules dites « basse consommation ». Il permettra par exemple, par des impulsions de courant, de générer une tension de 5Vdc.

## Revendications

1. Dispositif d'alimentation électrique comprenant une première borne d'entrée (IN1) et une deuxième borne d'entrée (IN2) entre lesquelles peut être appliquée une tension d'entrée alternative (Vin), comportant:
- Un redresseur (D6) connecté en série sur la deuxième borne d'entrée (IN2),
- Un oscillateur (OSC) connecté à la première borne d'entrée et au redresseur (D6), ledit oscillateur (OSC) comportant :
- une diode de type DIAC (DIAC) connectée d'une part à un point de connexion reliant une première résistance (R1) à un premier condensateur (C1) et d'autre part à un deuxième condensateur (C2), ledit deuxième condensateur (C2) étant connecté à une première borne aval (Y1),
- une résistance (R3) connectée entre le point de connexion de la diode de type DIAC (DIAC) avec le deuxième condensateur (C2) et une deuxième borne aval (Y2),
- Un convertisseur de tension (CONV), connecté à la première borne aval (Y1) pour être commandé par des impulsions de commande générées par ledit oscillateur (OSC) pour générer des impulsions de courant électriques et agencé pour fournir une tension de sortie (Vout) continue à partir de la tension entre la première borne d'entrée (IN1) et le redresseur (D6) par la génération desdites impulsions de courant électrique,
- L'oscillateur (OSC) étant agencé pour fournir lesdites impulsions de commande limitées en amplitude en-dessous d'une valeur seuil de tension par la diode de type DIAC,
- Le premier condensateur (C1) présentant une capacité dont la valeur détermine le nombre d'impulsions de commande sur chaque alternance de la tension d'entrée alternative,
- Le deuxième condensateur (C2) présentant une capacité dont la valeur détermine la durée de chaque impulsion de commande générée.

2. Dispositif selon la revendication 1, **caractérisé en ce que** le convertisseur (CONV) est de type abaisseur de tension.

3. Dispositif selon la revendication 1, **caractérisé en ce que** le convertisseur (CONV) est de type abaisseur-élévateur de tension.

4. Dispositif selon la revendication 1, **caractérisé en ce que** le convertisseur (CONV) est de type « flyback ».

5. Dispositif selon l'une des revendications 1 à 4, **caractérisé en ce qu'**il comporte un module électronique de régulation (MOD_REG) agencé pour réguler la tension de sortie à une valeur déterminée.

6. Système de commande d'une charge électrique comprenant au moins un interrupteur de commande (2) commuté entre un état ouvert et un état fermé pour commander une charge électrique (3) avec un courant de charge, **caractérisé en ce qu'**il comporte un dispositif d'alimentation (1) tel que défini dans l'une des revendications 1 à 5 et **en ce que** ledit dispositif d'alimentation est connecté en parallèle dudit interrupteur de commande (2) pour prélever une tension d'entrée (Vin) alternative lorsque l'interrupteur de commande est à l'état ouvert en vue de générer en sortie une tension de sortie (Vout).

7. Système selon la revendication 6, **caractérisé en ce qu'**il comporte un module électronique d'alimentation (MOD_ALlM) agencé pour prélever ledit courant de charge lorsque l'interrupteur de commande (2) est à l'état fermé et connecté à la sortie dudit dispositif d'alimentation (1) pour fournir ladite tension de sortie (Vout) lorsque l'interrupteur de commande (2) est à l'état fermé.

## Patentansprüche

1. Elektrische Versorgungsvorrichtung, die einen ersten Eingangsanschluss (IN1) und einen zweiten Eingangsanschluss (IN2), zwischen denen eine Eingangswechselspannung (Vin) angelegt werden kann, aufweist und die Folgendes umfasst:
- einen Gleichrichter (D6), der mit dem zweiten Eingangsanschluss (IN2) in Reihe geschaltet ist,
- einen Oszillator (OSC), der an den ersten Eingangsanschluss und an den Gleichrichter (D6) angeschlossen ist, wobei der Oszillator (OSC) Folgendes umfasst:
- eine Diode des DIAC-Typs (DIAC), die einerseits an einen Anschlussunkt, der einen ersten Widerstand (R1) mit einem ersten Kondensator (C1) verbindet, und andererseits an einen zweiten Kondensator (C2) angeschlossen ist, wobei der zweite Kondensator (C2) an einen ersten nachgeschalteten Anschluss (Y1) angeschlossen ist, und
- einen Widerstand (R3), der zwischen den Verbindungspunkt der Diode des DIAC-Typs (DIAC) mit dem zweiten Kondensator (C2) und einen zweiten nachgeschalteten Anschluss (Y2) geschaltet ist,
- einen Spannungsumsetzer (CONV), der mit dem ersten nachgeschalteten Anschluss (Y1) verbunden ist, um durch Steuerimpulse, die durch den Oszillator (OSC) erzeugt werden, gesteuert zu werden, um elektrische Stromimpulse zu erzeugen, und der dafür ausgelegt ist, anhand der Spannung zwischen dem ersten Eingangsanschluss (IN1) und dem Gleichrichter durch die Erzeugung der elektrischen Stromimpulse eine Ausgangsgleichspannung (Vout) zu liefern,
- wobei der Oszillator (OSC) dafür ausgelegt ist, die Steuerimpulse, deren Amplitude durch die Diode des DIAC-Typs auf einen Wert unterhalb eines Spannungsschwellenwertes beschränkt wird, zu liefern,
- wobei der erste Kondensator (C1) eine Kapazität besitzt, deren Wert die Anzahl von Steuerimpulsen während jeder Halbperiode der Eingangswechselspannung bestimmt,
- wobei der zweite Kondensator (C2) eine Kapazität besitzt, deren Wert die Dauer jedes erzeugten Steuerimpulses bestimmt.

2. Vorrichtung nach Anspruch 1, **dadurch gekennzeichnet, dass** der Umsetzer (CONV) vom Spannungserniedrigungstyp ist.

3. Vorrichtung nach Anspruch 1, **dadurch gekennzeichnet, dass** der Umsetzer (CONV) vom Spannungserniedrigungs-/Spannungserhöhungs-Typ ist.

4. Vorrichtung nach Anspruch 1, **dadurch gekennzeichnet, dass** der Umsetzer (CONV) vom "Flyback"-Typ ist.

5. Vorrichtung nach einem der Ansprüche 1 bis 4, **dadurch gekennzeichnet, dass** sie ein elektronisches Regulierungsmodul (MOD_REG) umfasst, das dafür ausgelegt ist, die Ausgangsspannung auf einen bestimmten Wert zu regulieren.

6. System zum Steuern einer elektrischen Last, das wenigstens einen Steuerschalter (2) umfasst, der zwischen einem geöffneten Zustand und einem geschlossenen Zustand umgeschaltet wird, um eine elektrische Last (3) mit einem Laststrom zu steuern, **dadurch gekennzeichnet, dass** sie eine Versorgungsvorrichtung (1), wie sie in einem der Ansprüche 1 bis 5 definiert ist, umfasst und dass die Versorgungsvorrichtung zu dem Steuerschalter (2) parallel geschaltet ist, um eine Eingangswechselspannung (Vin) abzugreifen, wenn der Steuerschalter im geöffneten Zustand ist, um am Ausgang eine Ausgangsspannung (Vout) zu erzeugen.

7. System nach Anspruch 6, **dadurch gekennzeichnet, dass** es ein elektronisches Versorgungsmodul (MOD_ALIM) umfasst, das dafür ausgelegt ist, den Laststrom abzugreifen, wenn der Steuerschalter (2) im geschlossenen Zustand ist, und mit dem Ausgang der Versorgungsvorrichtung (1) verbunden ist, um die Ausgangsspannung (Vout) zu liefern, wenn der Steuerschalter (2) im geschlossenen Zustand ist.

## Claims

1. Electrical power supply device comprising a first input terminal (IN1) and a second input terminal (IN2) between which an AC input voltage (Vin) may be applied, including:
- a rectifier (D6) that is connected in series to the second input terminal (IN2);
- an oscillator (OSC) that is connected to the first input terminal and the rectifier (D6), said oscillator (OSC) including:
- a DIAC-type diode (DIAC) that is connected both to a connection point connecting a first resistor (R1) to a first capacitor (C1) and to a second capacitor (C2), said second capacitor (C2) being connected to a first downstream terminal (Y1);
- a resistor (R3) that is connected between the connection point between the DIAC-type diode (DIAC) and the second capacitor (C2) and a second downstream terminal (Y2);
- a voltage converter (CONV), which is connected to the first downstream terminal (Y1) so as to be controlled by control pulses that are generated by said oscillator (OSC) in order to generate electric current pulses and which is arranged to deliver a DC output voltage (Vout) on the basis of the voltage between the first input terminal (IN1) and the rectifier (D6) by generating said electric current pulses;
- the oscillator (OSC) being arranged to deliver said control pulses, the amplitude of which is limited to below a voltage threshold value by the DIAC-type diode;
- the first capacitor (C1) having a capacitance the value of which determines the number of control pulses on each alternation of the AC input voltage;
- the second capacitor (C2) having a capacitance the value of which determines the duration of each generated control pulse.

2. Device according to Claim 1, **characterized in that** the converter (CONV) is a converter of voltage step-down type.

3. Device according to Claim 1, **characterized in that** the converter (CONV) is a converter of voltage step-down/step-up type.

4. Device according to Claim 1, **characterized in that** the converter (CONV) is a converter of flyback type.

5. Device according to one of Claims 1 to 4, **characterized in that** it includes an electronic regulating module (MOD_REG) that is arranged to regulate the output voltage so that it has a determined value.

6. System for controlling an electrical load comprising at least one control switch (2) that is switched between an open state and a closed state so as to control an electrical load (3) with a load current, **characterized in that** it includes a power supply device (1) such as defined in one of Claims 1 to 5 and **in that** said power supply device is connected in parallel with said control switch (2) so as to draw an AC input voltage (Vin) when the control switch is in the open state with a view to generating, as output, an output voltage (Vout).

7. System according to Claim 6, **characterized in that** it includes an electronic power supply module (MOD_ALIM) that is arranged to draw said load current when the control switch (2) is in the closed state and connected to the output of said power supply device (1) so as to deliver said output voltage (Vout) when the control switch (2) is in the closed state.
